(19) Europäisches Patentamt
European Patent Office
Office européen des brevets

(11) EP 1 479 700 A1

(12) **EUROPEAN PATENT APPLICATION**

(43) Date of publication:
**24.11.2004 Bulletin 2004/48**

(51) Int Cl.[7]: **C08F 2/38**, G03F 7/039

(21) Application number: **04252708.5**

(22) Date of filing: **10.05.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **08.05.2003 US 468774 P**

(71) Applicant: **E.I. DUPONT DE NEMOURS AND COMPANY**
**Wilmington, Delaware 19898 (US)**

(72) Inventors:
- **Sounik, James R.**
  **Corpus Christi Texas 78414 (US)**
- **Schadt, Frank Leonard III**
  **Wilmington Delaware 19806 (US)**
- **Fryd, Michael**
  **Philadelphia Pennsylvania 19106 (US)**

(74) Representative: **Towler, Philip Dean**
**Frank B. Dehn & Co.,**
**European Patent Attorneys,**
**179 Queen Victoria Street**
**London EC4V 4EL (GB)**

(54) **Processes for preparing photoresist compositions**

(57) An anhydrous, liquid phase process for preparing polymers of enhanced purity and low polydispersity comprising the steps of polymerization, optional purification, transesterification, optional purification, catalyst removal, and solvent exchange. The resultant polymer in solution can be used directly, without further processing steps, to prepare a photoresist composition.

EP 1 479 700 A1

## Description

### BACKGROUND OF THE INVENTION

#### Field of the Invention

The present invention relates to processes for preparing novel photoresist compositions utilizing polymers having a low polydispersity via the use of certain chain transfer agents (CTA) with certain monomers to provide said polymers. The polymers incorporating the chain transfer agents can be homopolymers, or made with additional monomers to provide copolymers. These polymers/copolymers are then converted into photoresist compositions for use as such.

#### Description of the Prior Art

There is a desire in the industry for higher circuit density in microelectronic devices that are made using lithographic techniques. One method of increasing the number of components per chip is to decrease the minimum feature size on the chip, which requires higher lithographic resolutions. The use of shorter wavelength radiation (e.g., deep UV, e.g. 190 to 315 nm) than the currently employed mid-UV spectral range (e.g. 350 nm to 450 nm) offers the potential for higher resolution. However, with deep UV radiation, fewer photons are transferred for the same energy dose and higher exposure doses are required to achieve the same desired photochemical response. Further, current lithographic tools have greatly attenuated output in the deep UV spectral region.

In order to improve sensitivity, several acid catalyzed chemically amplified resist compositions have been developed such as those disclosed in U.S. Pat. No. 4,491,628 (Jan. 1, 1985) and Nalamasu et al, "An Overview of Resist Processing for Deep UV Lithography", 3. Photopolymer Sci. Technol. 4, 299 (1991). The resist compositions generally comprise a photosensitive acid generator and an acid sensitive polymer. The polymer has acid sensitive side chain (pendant) groups that are bonded to the polymer backbone and are reactive towards a proton. Upon imagewise exposure to radiation, the photoacid generator produces a proton. The resist film is heated, and the proton causes catalytic cleavage of the pendant group from the polymer backbone. The proton is not consumed in the cleavage reaction and catalyzes additional cleavage reactions thereby chemically amplifying the photochemical response of the resist. The cleaved polymer is soluble in polar developers such as alcohol and aqueous base while the unexposed polymer is soluble in nonpolar organic solvents such as anisole. Thus the resist can produce positive or negative images of the mask depending on the selection of the developer solvent. Although chemically amplified resist compositions generally have suitable lithographic sensitivity, in certain applications, their performance can be improved by (i) increasing their thermal stability in terms of thermal decomposition and plastic flow and (ii) increasing their stability in the presence of airborne chemical contaminants. For example, in some semiconductor manufacturing processes, post image development temperatures (e.g. etching, implantation etc.) can reach 200°C. Brunsvold et al., U.S. Pat. Nos. 4,939,070 (issued Jul. 3, 1990) and 4,931,379 (issued Jun. 5,1990) disclose chemically amplified, acid sensitive resist compositions having increased thermal stability in the post image development stage. Brunsvold's resist compositions form a hydrogen bonding network after cleavage of the acid sensitive side chain group to increase the thermal stability of the polymer. Brunsvold avoids hydrogen-bonding moieties prior to the cleavage reaction because such hydrogen bonding is known to unacceptably destabilize the acid sensitive side chain. Although Brunsvold resists have suitable thermal stability, they also have lower sensitivity and therefore are unsuitable in certain applications.

With respect to chemical contamination, MacDonald et al. *SPIE* 14662 (1991) reported that due to the catalytic nature of the imaging mechanisms, chemically amplified resist systems are sensitive toward minute amounts of airborne chemical contaminants such as basic organic substances. These substances degrade the resulting developed image in the film and cause a loss of the linewidth control of the developed image. This problem is exaggerated in a manufacturing process where there is an extended and variable period of time between applying the film to the substrate and development of the image. In order to protect the resist from such airborne contaminants, the air surrounding the coated film is carefully filtered to remove such substances. Alternatively, the resist film is overcoated with a protective polymer layer. However, these are cumbersome processes.

Therefore, there was a need in the art for an acid sensitive, chemically amplified photoresist composition having high thermal stability and stability in the presence of airborne chemical contaminants for use in semiconductor manufacturing. Apparently, this was accomplished in the invention outlined in U.S. 5,625,020 which relates to a photosensitive resist composition comprising (i) a photosensitive acid generator and (ii) a polymer comprising hydroxystyrene and acrylate, methacrylate or a mixture of acrylate and methacrylate. The resist has high lithographic sensitivity and high thermal stability. The resist also exhibits surprising stability in the presence of airborne chemical contaminants. However, one of the problems with this composition was that the process of preparing the polymer as outlined in column 3, lines 10-30 and in Example 1 (of U.S. 5,625,020) results in poor conversion rates and chemical cleavage of some

groups in the repeat units. Thus, one of the objects of the present invention is an improved process for preparing the polymers used in the photoresist compositions.

The processes of the present invention provide methods which are fast, clean, anhydrous, and render the analysis of catalyst used therein an easy manner. Furthermore, if desired, the polymer in solution can be further treated to provide a novel photoresist composition which can be directly used without isolating the polymer beforehand.

Prior Art

The following references are disclosed as general background information.

1. U.S. 4,898,916 discloses a process for the preparation of poly(vinylphenol) from poly(acetoxystyrene) by acid catalyzed transesterification.
2. U.S. 5,239,015 discloses a process for preparing low optical density polymers and co-polymers for photoresists and optical applications.
3. U.S. 5,625,007 discloses a process for making low optical polymers and co-polymers for photoresists and optical applications.
4. U.S. 5,625,020 discloses a process for making a photoresist composition containing a photosensitive acid generator and a polymer comprising the reaction product of hydroxystyrene with acrylate, methacrylate or a mixture of acrylate and methacrylate.
5. EP 0813113 A1, Barclay, discloses an aqueous transesterification to deprotect the protected polymer.
6. WO 94 14858 A discloses polymerizing hydroxystyrene without the protecting group.
7. WO 98 01478 discloses chain transfer agents used to control the polydispersity of certain polymers.
8. WO 99 31144 discloses chain transfer agents used to control the polydispersity of certain polymers.

Other patents of interest are U.S. 4,679,843; U.S. 4,822,862; U.S. 4,912,173; U.S. 4,962.147; U.S. 5,087,772; U.S. 5,304,610; U.S. 5,789,522; U.S. 5,939,511; and U.S. 5,945,251.

All of the references described herein are incorporated herein by reference in their entirety.

SUMMARY OF THE INVENTION

This invention relates to a novel "one-pot", cost efficient process for the preparation of polymers such as homo-, co-, and terpolymers of (1) p-hydroxystyrene (PHS) or substituted p-hydroxystyrene (SPHS) /CTA alone or in combination with (2) alkyl acrylates (AA) and/or (3) other monomers such as ethylenically unsaturated copolymerizable monomers (EUCM). This unique and novel process involves multiple steps depending upon the polymer being formed and which when completed yield a polymer in solution and having enhanced purity and a low polydispersity. The steps start with (1) the polymerization of a substituted styrene and CTA (a single monomer alone but with the CTA if one is making a homopolymer) or substituted styrene and/or AA and/or EUCM in an alcohol solvent in the presence of a free radical initiator.

(2) Purification of the product from step (1) by fractionation with an alcohol solvent. (3) Transesterification of the product from step (2) in the presence of a catalyst. (4) Purification of the product from step (3) by another solvent, immiscible with the alcohol solvent, under distillation conditions. (5) Catalyst removal via ion exchange of the product from step (3). (6) A "Solvent Swap" of the product of step 5 wherein said alcohol solvent is removed and replaced by a photoresist type solvent. Some preferred embodiments include a substantially pure homopolymers of p-hydroxystyrene (PHS), copolymers of p-hydroxystyrene and tert-butyl acrylate, and terpolymer of p-hydroxystyrene, tert-butyl acrylate and styrene. These hydroxyl containing polymers have a wide variety of applications including as photoresists in microelectronics industry.

DETAILED DESCRIPTION OF THE INVENTION

The present invention thus provides, in part, a novel process for producing polymers that are used in photoresist compositions. The process is an improvement over the prior art and is quite efficient. Specifically, this invention provides a process for the preparation of a polymer of formula I,

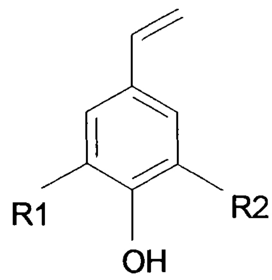

I;

either alone or in combination with an acrylate monomer having the formula II,

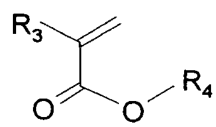

II;

and/or with one or more ethylenically unsaturated copolymerizable monomers (EUCM) selected from the group consisting of styrene, 4-methylstyrene, styrene alkoxide wherein the alkyl portion is $C_1$-$C_5$ straight or branch chain, maleic anhydride, dialkyl maleate, dialkyl fumarate and vinyl chloride, wherein alkyl is having 1 to 4 carbon atoms, comprising the following steps.

Step 1 - Polymerization

In this step, a substituted styrene monomer of formula III,

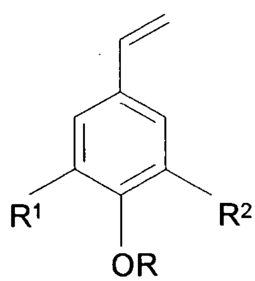

III

wherein R is either -OC(O)$R^5$ or -O$R^5$; either alone, but using a CTA (if preparing a homopolymer) or in combination with said monomer II, and/or one or more of said copolymerizable monomers (EUCM) is subjected to suitable polymerization conditions in a carboxylic alcohol solvent and in the presence of a free radical initiator at suitable temperature for a sufficient period of time to produce a polymer of corresponding composition.

In the above formulae I, II, and III, the following are the definitions:

i) $R^1$ and $R^2$ are the same or different and independently selected from the group consisting of:

hydrogen;
fluorine, chlorine or bromine;
alkyl or fluoroalkyl group having the formula $C_nH_xF_y$ where n is an integer from 1 to 4, x and y are integers from 0 to 2n+1, and the sum of x and y is 2n+1; and
phenyl or tolyl;

ii) $R^3$ is selected from the group consisting of:

hydrogen; and
methyl, ethyl, n-propyl, iso-propyl, n-butyl, i-butyl or t-butyl;

iii) $R^4$ is selected from the group consisting of methyl, ethyl, n-propyl, i-propyl, n-butyl, i-butyl, t-butyl, t-amyl, benzyl, cyclohexyl, 9-anthracenyl, 2-hydroxyethyl, cinnamyl, adamantyl, methyl or ethyl adamantyl, isobornyl, 2-ethoxyethyl, n-heptyl, n-hexyl, 2-hydroxypropyl, 2-ethylbutyl, 2-methoxypropyl, 2-(2-methoxy-ethoxyl), oxotetrahydrofuran, hydroxytrimethylpropyl, oxo-oxatricyclo nonyl, 2-naphthyl, 2-phenylethyl, phenyl.
iv) $R^5$ is $C_1$-$C_5$ alkyl, either straight or branch chain.

The chain transfer agents, herein referred to as CTA, are used with the styrene monomer and any other monomer mentioned herein. These CTA are a thiocarbonylthio compound selected from:

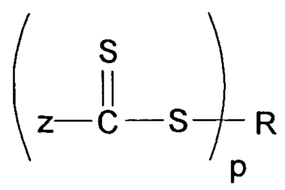

Formula C

and

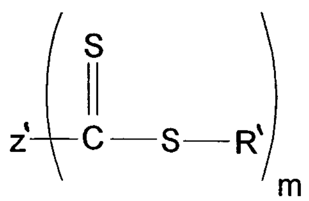

Formula D

having a chain transfer constant greater than about 0.1; and wherein:

z is selected from the group consisting of hydrogen, chlorine, optionally substituted alkyl, optionally substituted aryl, optionally substituted heterocyclyl, optionally substituted alkylthio, optionally substituted alkoxycarbonyl, optionally substituted aryloxycarbonyl (-COOR"), carboxy (-COOH), optionally substituted acyloxy (-$O_2$CR"), optionally substituted carbamoyl (-CONR"$_2$), cyano (-CN), dialkyl- or diaryl-phosphonato [-P(=O)OR"$_2$], dialkyl- or diaryl-phosphinato [-P(=O)R"$_2$], and a polymer chain formed by any mechanism;
z' is a m-valent moiety derived from a member of the group consisting of optionally substituted alkyl, optionally substituted aryl and a polymer chain; where the connecting moieties are selected from the group that consists of aliphatic carbon, aromatic carbon, and sulfur;
R is a p-valent moiety derived from a member of the group consisting of optionally substituted alkyl, an optionally substituted saturated, unsaturated or aromatic carbocyclic or heterocyclic ring; optionally substituted alkylthio; optionally substituted alkoxy; optionally substituted dialkylamino; an organometallic species; and a polymer chain prepared by any polymerization mechanism;
R' is selected from the group consisting of optionally substituted alkyl, an optionally substituted saturated, unsaturated or aromatic carbocyclic or heterocyclic ring; optionally substituted alkylthio; optionally substituted alkoxy; optionally substituted dialkylamino; an organometallic species; and a polymer chain prepared by any polymerization mechanism; in compounds C and D, R· or R'· is a free-radical leaving group that initiates free radical polymerization;
p is 1 or an integer greater than 1; and
m is an integer ≥2.

Some chain transfer agents applicable in the process of this invention are as follows:

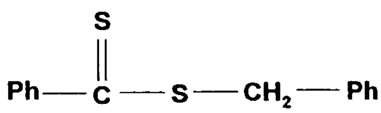

(3)

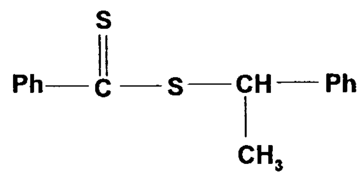

(4)

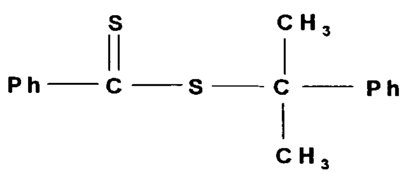

(5)

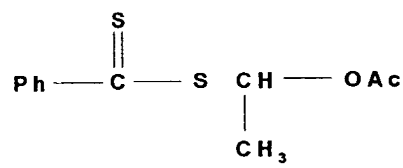

(6)

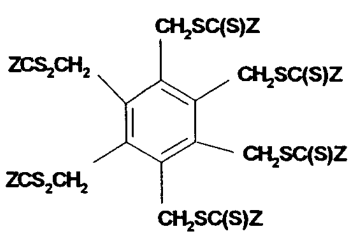

(7)

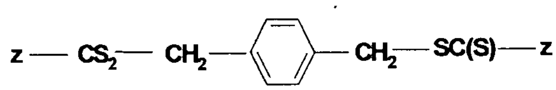

(8)

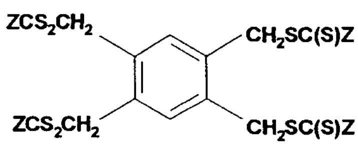

(9)

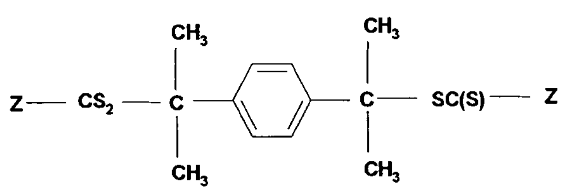

(10)

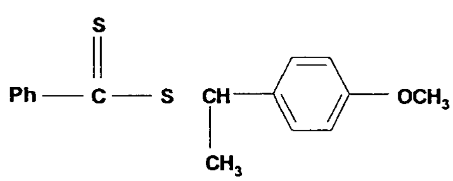

(11)

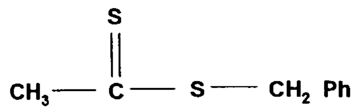

(12)

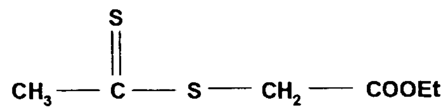

(13)

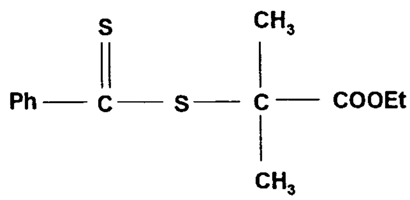

(14)

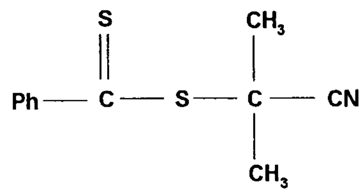

(15)

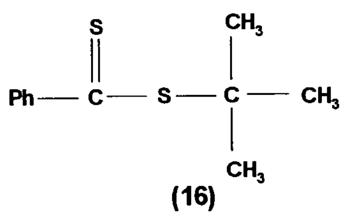

(16)

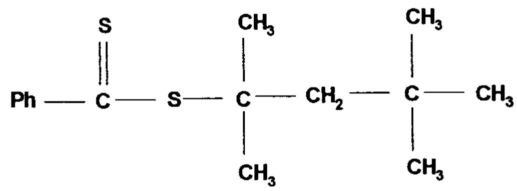

(17)

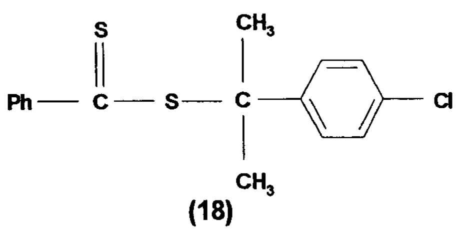

(18)

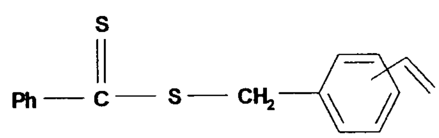

(19)

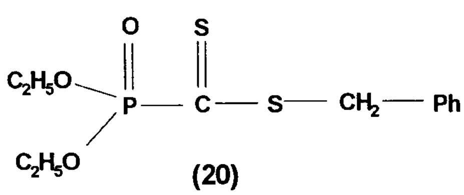

(20)

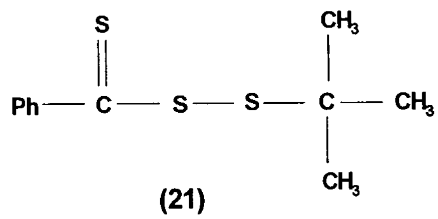

(21)

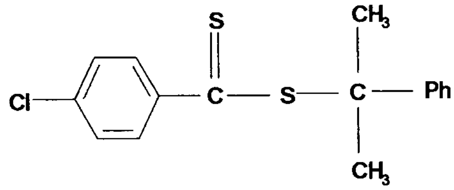

(22)

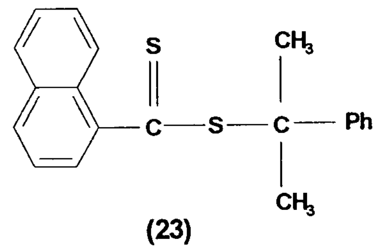

(23)

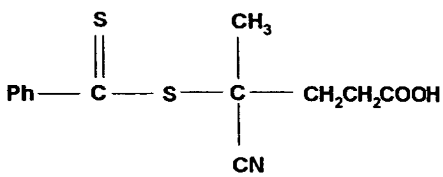

(24)

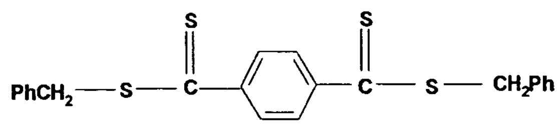

(25)

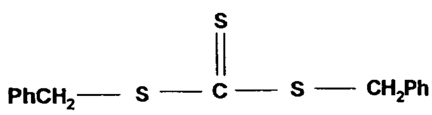

(26)

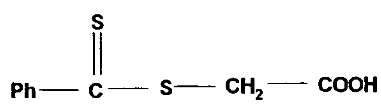

(27)

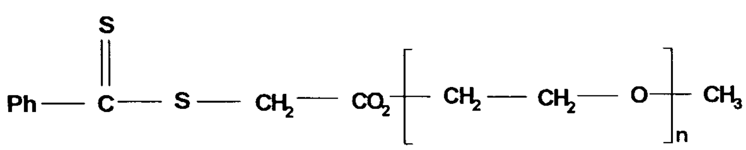

(28)

and

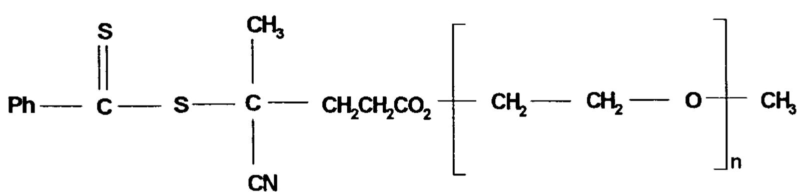

(29)

wherein Z is phenyl, and n is 1-22.

$$NC-C-S-C(=S)-S-(CH_2)11CH_3$$

(30)

It is also within the scope of the present invention to prepare a homopolymer of formula I from the monomer of formula III. As one preferred embodiment, polyhydroxystyrene (PHS) can be prepared from acetoxystyrene monomer (ASM) according to the novel processes set forth herein.

The scope of the present invention thus covers (a) a homopolymer of formula I derived from formula III monomer; (b) a copolymer derived from formula II and formula III monomers; (c) a copolymer derived from formula III monomers and the EUCM; and (d) a terpolymer derived from monomers of formula II, formula III and EUCM.

In conjunction with formula II (an acrylate monomer) set forth herein, some preferred acrylate monomers are (1) MAA - methyl adamantyl acrylate, (2) MAMA - methyl adamantyl methacrylate, (3) EAA - ethyl adamantyl acrylate, (4) EAMA - ethyl adamantyl methacrylate, (5) ETCDA - ethyl tricyclodecanyl acrylate, (6) ETCDMA - ethyl tricyclodecanyl methacrylate, (7) PAMA - propyl adamantyl methacrylate, (8) MBAMA - methoxybutyl adamantyl methacrylate, (9) MBAA - methoxybutyl adamantyl acrylate, (10) isobornylacrylate, (11) isobornylmethacrylate, (12) cyclohexylacrylate, and (13) cyclohexylmethacrylate. Other preferred acrylate monomers which can be used are (14) 2-methyl-2-adamantyl methacrylate; (15) 2-ethyl-2-adamantyl methacrylate; (16) 3-hydroxy-1-adamantyl methacrylate; (17) 3-hydroxy-1-adamantyl acrylate; (18) 2-methyl-2-adamantyl acrylate; (19) 2-ethyl-2-adamantyl acrylate; (20) 2-hydroxy-1,1,2-trimethylpropyl acrylate; (21) 5-oxo-4-oxatricyclo-non-2-yl acrylate; (22) 2-hydroxy-1,1,2-trimethylpropyl 2-methacrylate; (23) 2-methyl-2-adamantyl 2-methacrylate; (24) 2-ethyl-2-adamantyl 2-methacrylate; (25) 5-oxotetrahydrofuran-3-yl acrylate; (26) 3-hydroxy-1-adamantyl 2-methylacrylate; (27) 5-oxotetrahydrofuran-3-yl 2-methylacrylate; (28) 5-oxo-4-oxatricyclo-non-2-yl 2-methylacrylate.

Additional acrylates and other monomers that may be used in the present invention with the substituted styrene and CTA to form various copolymers include the following materials:

MONODECYL MALEATE
2-HYDROXY ETHYL METHACRYLATE
ISODECYL METHACRYLATE
HYDROXY PROPYL METHACRYLATE
ISOBUTYL METHACRYLATE
LAURYL METHACRYLATE
HYDROXY PROPYL ACRYLATE
METHYL ACRYLATE
T-BUTYLAMINOETHYL METHACRYLATE
ISOCYANATOETHYL METHACRYLATE
TRIBUTYLTIN METHACRYLATE
SULFOETHYL METHACRYLATE
BUTYL VINYL ETHER BLOCKED METHACRYLIC ACID
SILANE
ZONYL TM
ZONYL TA
T-BUTYL METHACRYLATE
2-PHENOXY ETHYL METHACRYLATE
ACETOACETOXYETHYL METHACRYLATE
2-PHENOXY ETHYL ACRYLATE
2-ETHOXY ETHOXY ETHYL ACRYLATE
B-CARBOXYETHYL ACRYLATE
MALEIC ANHYDRIDE
ISOBORNYL METHACRYLATE
ISOBORNYL ACRYLATE
METHYL METHACRYLATE
STYRENE
ETHYL ACRYLATE
2-ETHYL HEXYL METHACRYLATE
2-ETHYL HEXYL ACRYLATE
GLYCIDYL METHACRYLATE
N-BUTYL ACRYLATE
ACROLEIN
2-DIETHYLAMINOETHYL METHACRYLATE
ALLYL METHACRYLATE

VINYL OXAZOLINE ESTER OF TALL OIL
ACRYLONITRILE
METHACRYLIC ACID
STEARYL METHACRYLATE
MESO METHACRYLATE
ITACONIC ACID
ACRYLIC ACID
N-BUTYL METHACRYLATE
ETHYL METHACRYLATE
HYDROXY ETHYL ACRYLATE
ACRYLAMIDE

Co-polymers having polyhydroxystyrene (PHS) and one or more of the above acrylate monomers are some of the materials that are made by the novel processes of the present invention.

In another embodiment in this step 1, the reaction mixture may also comprise an additional co-solvent. The co-solvent is selected from the group consisting of tetrahydrofuran, methyl ethyl ketone, acetone, and 1,4-dioxane.

The carboxylic alcohol solvent is an alcohol having 1 to 4 carbon atoms and is selected from the group consisting of methanol, ethanol, isopropanol, tert-butanol, and combinations thereof. The amount of solvent (and/or second solvent) used is not critical and can be any amount which accomplishes the desired end result.

The free radical initiator may be any initiator that achieves the desired end result. The initiator may be selected from the group consisting of 2,2'-azobis(2,4-dimethylpentanenitrile), 2,2'-azobis(2-methylpropanenitrile), 2,2'-azobis (2-methylbutanenitrile), 1,1'-azobis(cyclohexanecarbonitrile), t-butyl peroxy-2-ethylhexanoate, t-butyl peroxypivalate, t-amyl peroxypivalate, diisononanoyl peroxide, decanoyl peroxide, succinic acid peroxide, di(n-propyl) peroxydicarbonate, di(sec-butyl) peroxydicarbonate, di(2-ethylhexyl) peroxydicarbonate, t-butylperoxyneodecanoate, 2,5-dimethyl-2,5-di(2-ethylhexanoylperoxy)hexane, t-amylperoxyneodecanoate, dimethyl 2,2'-azobisisobutyrate and combinations thereof.

As a preferred embodiment, the initiator is selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, and combinations thereof.

The amount of initiator is any amount that accomplishes the desired end result. However, as a preferred embodiment, said initiator is present to about three mole percent based upon the total moles of all of said monomers I, II, and said copolymerizable monomers.

The polymerization conditions are any temperature and pressure that will produce the desired end result. In general, the temperatures are from about 30°C to about 100°C, preferably from about 40°C to about 100°C, and most preferably from about 45°C to about 90°C. The pressure may be atmospheric, sub-atmospheric or super-atmospheric. The polymerization time is not critical, but generally will take place over a period of at least one minute in order to produce a polymer of corresponding composition.

Step 2 - Purification

After the polymerization of step 1, and prior to the transesterification of step 3, the polymer from step 1 is preferably subjected to a purification procedure wherein the same type carboxylic alcoholic solvent (first solvent) is used to purify the polymer via a multistep fractionation process. Additional first solvent is added to the polymer mixture of step 1, and the resultant slurry is stirred vigorously and/or heated to boiling (about 66°C) for several minutes, and then chilled to as low as 25°C and allowed to stand. This permits the slurry to produce a phase separation, and then the liquid is removed by centrifugation, filtration, decantation or by similar means. The process is repeated at least one more time until no further purification is identified, as for example, until a small sample of the decanted solvent, upon evaporation to dryness shows substantially no residue. This fractionation process is generally carried out 2 to 10 times, i.e. heating, cooling, separating, and the solvent replacement.

One of the important measures of the degree of impurity of the crude polymer produced from the polymerization of the monomers is the polydispersity value. In general, it is desirable to have a low value, for example, less than about 3; the lower value is indicative that the polymerization reaction was more uniform in chain length. The uniqueness of this purification step is that the desired polymer formed is, to some degree, not soluble in the solvent and that the undesired, low molecular weight average polymers and undesired monomers are soluble in the solvent. Thus the novel purification/fractionalization provides the removal of these undesirable materials. In general, the polydispersity of the crude polymer is measured before, during and after this purification/fractionalization step, with the objective of reducing this value by at least about 10% of what the value of the original crude polymer was before the purification treatment. Preferably, it is desirable to yield a product whose polydispersity is below about 2.0. It is to be

understood that polydispersity means the ratio of weight average molecular weight (Mw) over the number average molecular weight (Mn) as determined by Gel Permeation Chromatography (GPC).

Step 3 - Transesterification

In the transesterification step, the polymer/solvent mixture from step 2 is subjected to transesterification conditions in said alcohol solvent in the presence of a catalytic amount of a transesterification catalyst. The catalyst is such that it will not substantially react with the polymer, or said alkyl acrylate monomer II, or with said co-polymerizable monomers (EUCM). The catalyst is selected from the group consisting of (anhydrous) ammonia, lithium methoxide, lithium ethoxide, lithium isopropoxide, sodium methoxide, sodium ethoxide, sodium isopropoxide, potassium methoxide, potassium ethoxide, potassium isopropoxide, cesium methoxide, cesium ethoxide, cesium isopropoxide, and combinations thereof, wherein the carboxylic alkoxide anion is similar to the carboxylic alcohol solvent. It is also to be understood that the catalyst can be alkali metal hydroxides such as lithium hydroxide, sodium hydroxide, potassium hydroxide, cesium hydroxide and combinations thereof. If the monomer being used is one wherein R is $-OR^5$, then the catalyst is a strong acid, e.g. a mineral acid such as HCl.

The amount of catalyst employed is typically from about 0.1 mole percent to about 2 mole percent of monomer I present in the composition of said polymer.

In a preferred embodiment, the catalyst is added in step (b) as a solution in said alcohol solvent.

The temperature in step (b) is such that the transesterified byproduct ester formed can be continually removed from the reaction mixture to form the polymer of I, II, and said copolymerizable monomer. Such temperatures can be from about 50°C to about 200°C. In a preferred embodiment, the transesterification reaction is carried out at the reflux temperature of said alcohol solvent.

Step 4 - Purification

This optional purification step comes before the catalyst removal step (5). According to this step 4, there is added to the polymer in an alcoholic solution, a second solvent which is immiscible with said alcohol solvent until a second layer is formed. The mixture is then stirred vigorously or is heated to boiling for several minutes and then allowed to stand until cool. A discrete second layer is formed which is then removed by decantation or similar means, and the process is repeated until no further purification is identified, as for example, until a small sample of the decanted second (non-alcohol) solvent upon evaporation to dryness shows no residue. In this fashion, there are removed by-products and low weight average molecular weight materials.

The alcoholic solution of the polymer is then subjected to distillation to remove the remaining second solvent, which was miscible in the alcohol. Most often removal of the second solvent is accomplished by azeotropic distillation; the azeotropic mixture boiling below the boiling temperature of either the alcohol or the second solvent.

Typical second solvents useful for the method of this step include hexane, heptane, octane, petroleum ether, ligroin, lower alkyl halohydrocarbons, i.e., methylene chloride, and the like.

Step 5 - Catalyst Removal

In view of the nature of the catalyst employed in step 3, it is critical that it be removed from the system. In this step, there is employed a cation-exchange resin, preferably an acidic cation exchange resin, to accomplish the desired end result. An acidic ion exchange resin, such as sulfonated styrene/divinylbenzene cation exchange resin in hydrogenform, is preferably utilized in the present process. Suitable acidic exchange resins are available from Rohm and Haas Company, e.g. AMBERLYST 15 acidic ion exchange resin. These Amberlyst resins typically contain as much as 80,000 to 200,000 ppb of sodium and iron. Before being utilized in the process of the invention, the ion exchange resin must be treated with water and then a mineral acid solution to reduce the metal ion level. When removing the catalyst from the polymer solution, it is important that the ion exchange resin be rinsed with a solvent that is the same as, or at least compatible with, the polymer solution solvent. The procedure in this step may be similar to those procedures disclosed in U.S. 5,284,930 and U.S. 5,288,850.

Step 6 - Solvent Swap

In this step, the purified polymer is solvent exchanged with a third or aprotic/organic solvent which is a photoresist compatible solvent, and the alcoholic solvent is removed by distillation. This third solvent is at least one member selected from glycol ethers, glycol ether acetates and aliphatic esters having no hydroxyl or keto group. Examples of the solvent include glycol ether acetates such as ethylene glycol monoethyl ether acetate and propylene glycol monomethyl ether acetate (PGMEA) and esters such as ethyl-3-ethoxypropionate, methyl-3-methoxypropionate, among

which PGMEA is preferred. These solvents may be used alone or in the form of a mixture thereof.

Further examples of the third solvent include butyl acetate, amyl acetate, cyclohexyl acetate, 3-methoxybutyl acetate, methyl ethyl ketone, methyl amyl ketone, cyclohexanone, cyclopentanone, 3-ethoxyethyl propionate, 3-ethoxymethyl propionate, 3-methoxymethyl propionate, methyl acetoacetate, ethyl acetoacetate, diacetone alcohol, methyl pyruvate, ethyl pyruvate, propylene glycol monomethyl ether, propylene glycol monoethyl ether, propylene glycol monomethyl ether propionate, propylene glycol monoethyl ether propionate, ethylene glycol monomethyl ether, ethylene glycol monoethyl ether, diethylene glycol monomethyl ether, diethylene glycol monoethyl ether, 3-methyl-3-methoxybutanol, N-methylpyrrolidone, dimethylsulfoxide, γ-butyrolactone, propylene glycol methyl ether acetate, propylene glycol ethyl ether acetate, propylene glycol propyl ether acetate, methyl lactate, ethyl lactate, propyl lactate, and tetramethylene sulfone. Of these, the propylene glycol alkyl ether acetates and alkyl lactates are especially preferred. The solvents may be used alone or in admixture of two or more. An exemplary useful solvent mixture is a mixture of a propylene glycol alkyl ether acetate and an alkyl lactate. It is noted that the alkyl groups of the propylene glycol alkyl ether acetates are preferably those of 1 to 4 carbon atoms, for example, methyl, ethyl and propyl, with methyl and ethyl being especially preferred. Since the propylene glycol alkyl ether acetates include 1,2- and 1,3-substituted ones, each includes three isomers depending on the combination of substituted positions, which may be used alone or in admixture. It is also noted that the alkyl groups of the alkyl lactates are preferably those of 1 to 4 carbon atoms, for example, methyl, ethyl and propyl, with methyl and ethyl being especially preferred.

When the propylene glycol alkyl ether acetate is used as the solvent, it preferably accounts for at least 50% by weight of the entire solvent. Also when the alkyl lactate is used as the solvent, it preferably accounts for at least 50% by weight of the entire solvent. When a mixture of propylene glycol alkyl ether acetate and alkyl lactate is used as the solvent, that mixture preferably accounts for at least 50% by weight of the entire solvent. In this solvent mixture, it is further preferred that the propylene glycol alkyl ether acetate is 60 to 95% by weight and the alkyl lactate is 40 to 5% by weight. A lower proportion of the propylene glycol alkyl ether acetate would invite a problem of inefficient coaling whereas a higher proportion thereof would provide insufficient dissolution and allow for particle and foreign matter formation. A lower proportion of the alkyl lactate would provide insufficient dissolution and cause the problem of many particles and foreign matter whereas a higher proportion thereof would lead to a composition which has too high a viscosity to apply and loses storage stability.

Usually the solvent is used in amounts of about 300 to 2,000 parts, preferably about 400 to 1,000 parts by weight per 100 parts by weight of the solids in the chemically amplified positive resist composition. The concentration is not limited to this range as long as film formation by existing methods is possible.

Step 7 - Addition Reaction Blocking

The substantially pure hydroxyl containing polymer in solution (i.e. third solvent) from step 6 may then be subjected to an additional reaction to provide said polymer with protective or blocking groups (sometimes referred to as acid labile groups) in order to protect the functional/hydroxyl groups. In some cases, this blocking can be either fully blocked or partially blocked. In this step, the polymer in solution from step 6 is reacted with a vinyl ether compound and/or a dialkyl dicarbonate in the presence of a catalyst in the aprotic solvent (i.e. third solvent). When the polymer is reacted with the vinyl ether, it is done in the presence of an acid catalyst followed by adding a base thereto to neutralize it and thus stop the reaction; this is generally called an acetalization wherein an acetal derivatized hydroxyl containing polymer is formed. When the polymer from step 6 is reacted with a dialkyl dicarbonate, this is an alcoholysis by use of an anhydride (dicarbonate) in the presence of base catalyst which is used as a reaction catalyst.

The vinyl ethers suitable for use as a protective group include those falling within the formula

$$C\,(R_6)\,(R_7) = C\,(R_8) - O - R_9$$

wherein $R_6$, $R_7$ and $R_8$ independently represent a hydrogen atom or a straight-chain, branched, cyclic or heterocyclic alkyl group containing 1 to 6 carbon atoms, and $R_9$ represents a straight-chain, branched, cyclic or heterocyclic alkyl or aralkyl group containing 1 to 10 carbon atoms which may be substituted with a halogen atom, an alkoxy group aralkyl oxycarbonyl group and/or alkyl carbonyl amino group.

The vinyl ether compounds represented by the general formula, described above include vinyl ethers such as methyl vinyl ether, ethyl vinyl ether, n-butyl vinyl ether, tert-butyl vinyl ether, 2-chloro-ethyl vinyl ether, 1-methoxyethyl vinyl ether, 1-benzyloxyethyl vinyl ether, etc.; and isopropenyl ethers such as isopropenyl methyl ether, isopropenyl ethyl ether, etc.

Preferable examples of cyclic vinyl ethers include 3,4-dihydro-2H-pyran, etc., and preferable examples of divinyl ethers include butanediol-1,4-divinyl ether, ethylene glycol divinyl ether, triethylene glycol divinyl ether, etc.

These vinyl ether compounds can be used alone or in combination thereof. The vinyl ether compounds in

total are used preferably in a ratio of 0.1 to 0.7 mol equivalent to the phenolic hydroxyl or carboxyl group of the alkali-soluble polymer having phenolic hydroxyl or carboxyl group.

Preferable examples of the dialkyl dicarbonate used in the present invention include di-tert-butyl dicarbonate. As with the vinyl ether compounds, the amount of the dialkyl dicarbonate used is preferably 0.1 to 0.7 mol equivalent to the phenolic hydroxyl or carboxyl group of the alkali-soluble polymer having a phenolic hydroxyl or carboxyl group.

In the present invention, at least one vinyl ether compound and at least one dialkyl dicarbonate can be used simultaneously for protection of a single alkali-soluble polymer described above.

If the resist materials to be synthesized are used as a component of a resist composition exposed with e.g. KrF excimer laser radiation, it is preferable to use a catalyst showing no absorption at 248 nm, i.e. the exposure wavelength of KrF excimer laser. Accordingly, when an acid is used as the reaction catalyst, the acid preferably does not have a benzene ring. Examples of acids which can be used as the reaction catalyst in the present invention include mineral acids such as hydrochloric acid, sulfuric acid, etc., organic sulfonic acids such as methanesulfonic acid, camphorsulfonic acid, etc. or halocarboxylic acids such as trifluoroacetic acid, trichloroacetic acid, etc. The amount of the acid used is preferably 0.1 to 10 mmol equivalents to the phenolic hydroxyl or carboxyl group of the polymer having a phenolic hydroxyl or carboxyl group.

In the case where (+/-) camphorsulfonic acid is used as the reaction catalyst in the form of a solution thereof in propylene glycol monomethyl ether acetate, if said solution is heated or stored for a long period of time, the propylene glycol monomethyl ether acetate is hydrolyzed to generate propylene glycol monomethyl ether (PGME) by which the reaction is significantly inhibited. Accordingly, the solution of (+/-)camphorsulfonic acid in propylene glycol monomethyl ether acetate should be prepared just before use.

When a dialkyl dicarbonate is used as a compound to be reacted with the alkali-soluble polymer having a phenolic hydroxyl or carboxyl group, a base is used as the reaction catalyst, while when a vinyl ether compound is used as a compound to be reacted with the alkali-soluble polymer having a phenolic hydroxyl or carboxyl group, a base is used as the reaction stopper. As these bases, usual bases which are optically decomposable or not decomposable and are used as conventional additives in chemically amplified resists can be preferably used. Examples of these bases include ammonia, organic amines such as triethylamine, dicyclohexyl methylamine, etc.; ammonium hydroxides represented by tetramethylammonium hydroxide (TMAH), sulfonium hydroxides represented by triphenylsulfonium hydroxide, iodonium hydroxides represented by diphenyliodonium hydroxide and conjugated salts of these iodonium hydroxides, such as triphenylsulfonium acetate, triphenylsulfonium camphanate, triphenylsulfonium camphorate, etc. These reaction base catalysts or reaction stoppers are preferably those which when formed into a resist composition, do not have influence on resist sensitivity, and in particular, optically decomposable bases are preferable. When the amine is present in the resist composition, attention should be paid because sensitivity may be lowered. Further, inorganic bases are not preferable because many of them contain metal ions that contaminate the substrate such as silicon wafer etc. If the polymer is neither isolated nor purified according to the method for preparing a resist composition of the present invention, the main cause for instability of the polymer in the step of isolation and purification thereof can be eliminated. If a base is used as the reaction stopper, the stability of the polymer is further improved, and even in the case of the polymer having acetate as a protective group, its stability for 2 months or more at room temperature is confirmed.

The conditions for reacting the alkali-soluble polymer having a phenolic hydroxyl or carboxyl group with the vinyl ether compound or the dialkyl dicarbonate may be the same as in the prior art, and the reaction may be conducted under the same conditions as in the prior art. In this reaction, if water is present in the reaction system, the vinyl ether is decomposed to formaldehyde and alcohol, and the degree of protection by the vinyl ether compound becomes lower than the set value. As the drop of the degree of polymer has a significant effect on the thickness loss of the resist film in developer, the moisture content should preferably be minimized in the reaction system. That is, if the moisture content in the reaction system is controlled to be as low as possible, the degree of protection can be in a certain narrow range, to significantly reduce variations in degrees of protection as compared with the conventional reaction. Accordingly, the moisture content of the reaction solution before the reaction should be measured by the Karl Fischer method in order to confirm that the moisture content is less than about 5,000 ppm, preferably less than about 1,000 ppm. For example, if the moisture content is more than 5,000 ppm, attention should be paid such that the degree of protection is within a set value, for example by increasing the amount of the vinyl ether compound as necessary. The reaction temperature and reaction time are e.g. 25°C, and 6 hours respectively, but if the protective group is ketal, are e.g. 0°C and 2 hours respectively.

If a single alkali-soluble polymer is protected by both a vinyl ether compound and a dialkyl dicarbonate, usually the polymer is subjected to protection reaction with the vinyl ether compound in the presence of an acid catalyst and then subjected to protection reaction with the dialkyl dicarbonate in the presence of a base catalyst.

The usable base includes radiation-sensitive bases or usual bases not sensitive to radiation. These bases are not necessarily required for resist formulation, but because their addition can prevent the deterioration of pattern characteristics even in the case where the treatment step is conducted with delay, so their addition is preferable. Further,

their addition also results in improvements in clear contrast.

Among radiation-sensitive base compounds suitable as bases, particularly preferable examples include e.g. triphenylsulfonium hydroxide, triphenylsulfonium acetate, triphenylsulfonium phenolate, tris-(4-methylphenyl) sulfonium hydroxide, tris-(4-methylphenyl)sulfonium acetate, tris-(4-methylphenyl)sulfonium phenolate, diphenyliodonium hydroxide, diphenyliodonium acetate, diphenyliodonium phenolate, bis-(4-tert-butylphenyl)iodonium hydroxide, bis-(4-tert-butylphenyl)iodonium acetate, bis-(4-tert-butylphenyl)iodonium phenolate, etc.

Further, the base compounds not sensitive to radiation include e.g. (a) ammonium salts such as tetramethylammonium hydroxide, tetrabutylammonium hydroxide, etc., (b) amines such as n-hexylamine, dodecylamine, aniline, dimethylaniline, diphenylamine, triphenylamine, diazabicyclooctane, diazabicycloundecane, etc., and (c) basic heterocyclic compounds such as 3-phenylpyridine, 4-phenylpyridine, lutidine and 2,6-di-tert-butylpyridine.

These base compounds can be used alone or in combination thereof. The amount of the base compound added is determined according to the amount of the photo acid-generating compound and the photo acid-generating ability of the photoacid generator. Usually the base compound is used in a ratio of 10 to 110 mol %, preferably 25 to 95 mole % relative to the amount of the photo acid-generating compound.

Step 8 - Neutralization

After the reaction of step 7 is finished, a base (for example triphenylsulfonium acetate or the like) is added whereby the acid catalyst is neutralized and inactivated to stop the reaction, so that a polymer solution having storage stability can be obtained. Theoretically, addition of the base in an equivalent amount to the acid is sufficient to inactivate the acid, but because storage stability can be further secured by adding about 10% excess base, addition of about 1.1 equivalents of the base to 1 equivalent of the acid is preferable. This excess base will be taken into consideration in order to determine the amount of another base added as an additive for preparing the resist.

It is also feasible in this neutralization step to use an ion exchange material as previously mentioned hereinbefore.

Step 9 - Photoacid Generator Addition

The resist composition is prepared without isolating the resist material by directly adding to the resist material solution (prepared as described above) a photoacid generating compound capable of generating an acid upon exposure to actinic radiation (photoacid generator) and if necessary a base and additives for improvement of optical and mechanical characteristics, a film forming property, adhesion with the substrate, etc. optionally in the form of a solution. The viscosity of the composition is regulated by addition of solvent, if necessary. The solvent used in preparing the resist composition is not necessarily limited to the type of third solvent having been used in step 6, and it is possible to use any other solvent which is conventionally used in preparation of a resist composition. Further, any photo acid-generating compounds and other additives, which are used conventionally in chemically amplified resists, can also be used. The total solid content in the resist composition is preferably in the range of 9 to 50% by weight, more preferably 15 to 25% by weight, relative to the solvent.

The photoacid generator is a compound capable of generating an acid upon exposure to high energy radiation. Preferred photoacid generators are sulfonium salts, iodonium salts, sulfonyldiazomethanes, and N-sulfonyloxyimides. These photoacid generators are illustrated below and they may be used alone or in admixture of two or more.

Sulfonium salts are salts of sulfonium cations with sulfonates. Exemplary sulfonium cations include triphenylsulfonium, (4-tert-butoxyphenyl)diphenylsulfonium, bis(4-tert-butoxy-phenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris (3,4-di-tert-butoxyphenyl)sulfonium, diphenyl(4-thiophenoxyphenyl)sulfonium, (4-tert-butoxycarbonyl-methyloxyphenyl)diphenylsulfonium, tris(4-tert-butoxycarbonylmethyloxyphenyl)sulfonium, (4-tert-butoxyphenyl)bis(4-dimethylaminophenyl)-sulfonium, tris(4-dimethylaminophenyl)sulfonium, 2-naphthyldiphenylsulfonium, dimethyl-2-naphthylsulfonium, 4-hydroxyphenyldimethylsulfonium, 4-methoxyphenyl-dimethylsulfonium, trimethylsulfonium, 2-oxocyclohexylcyclohexyl-methylsulfonium, trinaphthylsulfonium, and tribenzylsulfonium. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4,4-toluenesulfonyloxy-benzenesulfonate, naphthalenesulfonate, camphorsulfonate, octanesulfonate, dodecylbenzenesulfonate, butanesulfonate, and methanesulfonate. Sulfonium salts based on combination of the foregoing examples are included.

Iodonium salts are salts of iodonium cations with sulfonates. Exemplary iodonium cations are aryliodonium cations including diphenyliodonium, bis(4-tert-butylphenyl)iodonium, 4-tert-butoxyphenylphenyliodonium, and 4-methoxyphenylphenylodonium. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4,4-toluenesulfonyloxy-benzenesulfonate, naphthalenesulfonate, camphorsulfonate, octanesulfonate, dodecylbenzenesulfonate, butanesulfonate, and methanesulfonate. Iodonium salts based on combination of the foregoing examples are included.

Exemplary sulfonyldiazomethane compounds include bissulfonyldiazomethane compounds and sulfonylcarbonyldiazomethane compounds such as bis(ethylsulfonyl)diazo-methane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)-diazomethane, bis(4-methylphenylsulfonyl)diazomethane, bis(2,4-dimethylphenylsulfonyl)diazomethane, bis(2-naphthylsulfonyl)-diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenyl-sulfonyl-2-naphthoyldiazomethane, methylsulfonylbenzoyldiazomethane, and tert-butoxycarbonyl-4-methylphenylsulfonyldiazomethane.

N-sulfonyloxyimide photoacid generators include combinations of imide skeletons with sulfonates. Exemplary imide skeletons are succinimide, naphthalene dicarboxylic acid imide, phthalimide, cyclohexyldicarboxylic acid imide, 5-norbornene-2,3-dicarboxylic acid imide, and 7-oxabicyclo [2,2,1]-5-heptene-2,3-dicarboxylic acid imide. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Benzoinsulfonate photoacid generators include benzoin tosylate, benzoin mesylate, and benzoin butanesulfonate.

Pyrogallol trisulfonate photoacid generators include pyrogallol, fluoroglycine, catechol, resorcinol, hydroquinone, in which all the hydroxyl groups are replaced by trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Nitrobenzyl sulfonate photoacid generators include 2,4-dinitrobenzyl sulfonate, 2-nitrobenzyl sulfonate, and 2,6-dinitrobenzyl sulfonate, with exemplary sulfonates including trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate. Also useful are analogous nitrobenzyl sulfonate compounds in which the nitro group on the benzyl side is replaced by a trifluoromethyl group.

Sulfone photoacid generators include bis(phenylsulfonyl)methane, bis(4-methylphenylsulfonyl)methane, bis (2-naphthylsulfonyl)methane, 2,2-bis(phenylsulfonyl)propane, 2,2-bis(4-methylphenylsulfonyl)propane, 2,2-bis (2-naphthylsulfonyl)propane, 2-methyl-2-(p-toluenesulfonyl)-propiophenone, 2-cyclohexylcarbonyl-2-(p-toluenesulfonyl)propane, and 2,4-dimethyl-2-(p-toluenesulfonyl)pentan-3-one.

Photoacid generators in the form of glyoxime derivatives include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-o-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexylsulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime.

Of these photoacid generators, the sulfonium salts, bissulfonyldiazomethane compounds, and N-sulfonyloxyimide compounds are preferred.

While the anion of the optimum acid to be generated differs depending on the ease of scission of acid labile groups introduced in the polymer, an anion which is nonvolatile and not extremely diffusive is generally chosen. The preferred anions include benzenesulfonic acid anions, toluenesulfonic acid anions, 4,4-toluenesulfonyloxybenzenesulfonic acid anions, pentafluorobenzenesulfonic acid anions, 2,2,2-trifluoroethanesulfonic acid anions, nonafluorobutanesulfonic acid anions, heptadecafluorooctanesulfonic acid anions, and camphorsulfonic acid anions.

In the chemically amplified positive resist composition, an appropriate amount of the photoacid generator is 0 to 20 parts, and especially 1 to 10 parts by weight per 100 parts by weight of the solids in the composition. The photoacid generators may be used alone or in a mixture of two or more. The transmittance of the resist film can be controlled by using a photoacid generator having a low transmittance at the exposure wavelength and adjusting the

amount of the photoacid generator added.

In conjunction with the all steps set forth above, it is critical that all steps be conducted on an anhydrous basis, i.e. wherein the water level is less than about 5,000 parts per million (ppm), in order to avoid possible side reactions and provide a mechanism to provide a convenient and direct route to a resist composition without having to isolate the polymer product and then carry out additional processing steps.

It is to be understood that in conjunction with the purification steps 2 and 4, set forth above, it is within the scope of this invention to use both of these steps, only one of these steps or neither of these steps.

<u>Protective Groups for Removal by PAC Catalysis</u>

The fluorine-containing copolymers of the resist compositions of this invention can contain one or more components having protected acidic fluorinated alcohol groups (e.g., $-C(R_f)(R'_f)OR_a$, where $R_a$ is not H) or other acid groups that can yield hydrophilic groups by the reaction with acids or bases generated photolytically from photoactive compounds (PACs). A given protected fluorinated alcohol group contains a protecting group that protects the fluorinated alcohol group from exhibiting its acidity while in this protected form. A given protected acid group ($R_a$) is normally chosen on the basis of its being acid-labile, such that when acid is produced upon imagewise exposure, it will catalyze deprotection of the protected acidic fluorinated alcohol groups and production of hydrophilic acid groups that are necessary for development under aqueous conditions. In addition, the fluorine-containing copolymers will also contain acid functionality that is not protected (e.g., $-C(R_f)(R'_f)OR_a$, where $R_a$ = H).

An alpha-alkoxyalkyl ether group (i.e., $R_a = OCH_2R_b$, $R_b = C_1$-$C_{11}$ alkyl) is a preferred protecting group for the fluoroalcohol group in order to maintain a high degree of transparency in the photoresist composition. An illustrative, but non-limiting, example of an alpha-alkoxyalkyl ether group that is effective as a protecting group, is methoxy methyl ether (MOM). A protected fluoroalcohol with this particular protecting group can be obtained by reaction of chloromethylmethyl ether with the fluoroalcohol. An especially preferred protected fluoroalcohol group has the structure:

$$-C(R_f)(R_{f,})O-CH_2OCH_2R_{15}$$

wherein $R_f$ and $R'_f$ are the same or different fluoroalkyl groups of from 1 to 10 carbon atoms or taken together are $(CF_2)_n$ wherein n is 2 to 10; $R_{15}$ is H, a linear alkyl group of 1 to 10 carbon atoms, or a branched alkyl group of 3 to 10 carbon atoms.

Carbonates formed from a fluorinated alcohol and a tertiary aliphatic alcohol can also be used as protected acidic fluorinated alcohol groups.

The fluorine-containing copolymers made according to this invention can also contain other types of protected acidic groups that yield an acidic group upon exposure to acid. Examples of such types of protected acidic groups include, but are not limited to: A) esters capable of forming, or rearranging to, a tertiary cation; B) esters of lactones; C) acetal esters; D) β-cyclic ketone esters; E) α-cyclic ether esters; and F) esters which are easily hydrolyzable because of anchimeric assistance, such as MEEMA (methoxy ethoxy ethyl methacrylate).

Some specific examples in category A) are t-butyl ester, 2-methyl-2-adamantyl ester, and isobornyl ester.

In this invention, often, but not always, the components having protected groups are repeat units having protected acid groups that have been incorporated in the base copolymer resins of the compositions (as discussed above). Frequently the protected acid groups are present in one or more comonomers that are polymerized to form a given copolymeric base resin of this invention. Alternatively, in this invention, a copolymeric base resin can be formed by copolymerization with an acid-containing comonomer and then subsequently acid functionality in the resulting acid-containing copolymer can be partially or wholly converted by appropriate means to derivatives having protected acid groups.

<u>Photoactive Component (PAC)</u>

The copolymers of this invention can be used to make photoresists by combining the copolymers with at least one photoactive component, a compound that affords either acid or base upon exposure to actinic radiation. If an acid is produced upon exposure to actinic radiation, the PAC is termed a photoacid generator (PAG). If a base is produced upon exposure to actinic radiation, the PAC is termed a photobase generator (PBG). Several suitable photoacid generators are disclosed in WO 00/66575.

Suitable photoacid generators for this invention include, but are not limited to, 1) sulfonium salts (structure I), 2) iodonium salts (structure II), and 3) hydroxamic acid esters, such as structure III.

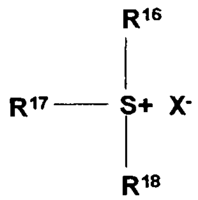

I

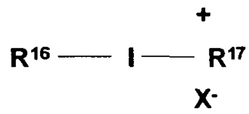

II

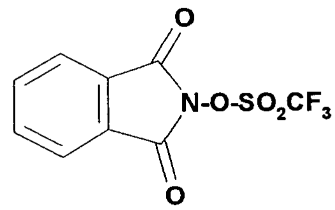

III

In structures I - II, $R_{16}$-$R_{18}$ are independently substituted or unsubstituted aryl or substituted or unsubstituted $C_7$-$C_{20}$ alkylaryl (aralkyl). Representative aryl groups include, but are not limited to, phenyl and naphthyl. Suitable substituents include, but are not limited to, hydroxyl (-OH) and $C_1$-$C_{20}$alkyloxy (e.g., $-OC_{10}H_{21}$). The anion, $X^-$, in structures I-II can be, but is not limited to, $SbF_6$(hexafluoroantimonate), $CF_3SO_3$ (trifluoromethylsulfonate = triflate), and $C_4F_9SO_3$(perfluorobutylsulfonate).

Dissolution Inhibitors and Additives

Various dissolution inhibitors can be added to photoresists derived from the copolymers of this invention. Ideally, dissolution inhibitors (DIs) for far and extreme UV resists (e.g., 193 nm resists) should be designed/chosen to satisfy multiple materials needs including dissolution inhibition, plasma etch resistance, and adhesion behavior of resist compositions comprising a given DI additive. Some dissolution inhibiting compounds also serve as plasticizers in resist compositions. Several suitable dissolution inhibitors are disclosed in WO 00/66575.

Positive-Working and Negative-Working Photoresists

The photoresists of this invention can either be positive-working photoresists or negative-working photoresists, depending upon the choice of components in the fluoropolymer, the presence or absence of optional dissolution inhibitor and crosslinking agents, and the choice of developer (solvent used in development). In positive-working photoresists, the resist polymer becomes more soluble and/or dispersible in a solvent used in development in the imaged or irradiated areas whereas in a negative-working photoresist, the resist polymer becomes less soluble and/or dispersible in the imaged or irradiated areas. In one preferred embodiment of this invention, irradiation causes the generation of acid or base by the photoactive component discussed above. The acid or base may catalyze removal of protecting groups from the fluoroalcohol and optionally other acidic groups present in a fluorine-containing polymer comprising a repeat unit derived from at least one ethylenically unsaturated compound containing a fluoroalcohol functional group or a protected fluoroalcohol functional group having the structure:

$$C(R_f)(R'_f)OR_a$$

wherein $R_f$ and $R'_f$ are the same or different fluoroalkyl groups of from 1 to about 10 carbon atoms or taken together are $(CF_2)n$ wherein n is 2 to 10 and $R_a$ is hydrogen or a protected functional group. Development in an aqueous base such as tetramethylammonium hydroxide would result in the formation of a positive image whereas development in an organic solvent or critical fluid (having moderate to low polarity), would result in a negative-working system in which exposed areas remain and unexposed areas are removed. Positive-working photoresists are preferred. A variety of different crosslinking agents can be employed as required or optional photoactive component(s) in the negative-working mode of this invention. (A crosslinking agent is required in embodiments that involve insolubilization in developer solution as a result of crosslinking, but is optional in preferred embodiments that involve insolubilization in developer solution as a result of polar groups being formed in exposed areas that are insoluble in organic solvents and critical fluids having moderate/low polarity). Suitable crosslinking agents include, but are not limited to, various bis-azides, such as 4,4'-diazidodiphenyl sulfide and 3,3'-diazidodiphenyl sulfone. Preferably, a negative-working resist composition containing a crosslinking agent(s) also contains suitable functionality (e.g., unsaturated C=C bonds) that can react with the reactive species (e.g., nitrenes) that are generated upon exposure to UV to produce crosslinked polymers that are not soluble, dispersed, or substantially swollen in developer solution, that consequently imparts negative-working characteristics to the composition.

Other Components

Photoresists of this invention can contain additional optional components. Examples of optional components include, but are not limited to, resolution enhancers, adhesion promoters, residue reducers, coating aids, plasticizers, and $T_g$ (glass transition temperature) modifiers.

Process Steps

Imagewise Exposure

The photoresist compositions of this invention are sensitive in the ultraviolet region of the electromagnetic spectrum and especially to those wavelengths ≤ 365 nm. Imagewise exposure of the resist compositions of this invention can be done at many different UV wavelengths including, but not limited to, 365 nm, 248 nm, 193 nm, 157 nm, and lower wavelengths. Imagewise exposure is preferably done with ultraviolet light of 248 nm, 193 nm, 157 nm, or lower wavelengths, more preferably it is done with ultraviolet light of 193 nm, 157 nm, or lower wavelengths, and most preferably, it is done with ultraviolet light of 157 nm or lower wavelengths. Imagewise exposure can either be done digitally with a laser or equivalent device or non-digitally with use of a photomask. Digital imaging with a laser is preferred. Suitable laser devices for digital imaging of the compositions of this invention include, but are not limited to, an argon-fluorine excimer laser with UV output at 193 nm, a krypton-fluorine excimer laser with UV output at 248 nm, and a fluorine (F2) laser with output at 157 nm. Since use of UV light of lower wavelength for imagewise exposure corresponds to higher resolution (lower resolution limit), the use of a lower wavelength (e.g., 193 nm or 157 m or lower) is generally preferred over use of a higher wavelength (e.g., 245 nm or higher).

Development

The fluorine-containing copolymers in the resist compositions of this invention must contain sufficient functionality for development following imagewise exposure to UV light. Preferably, the functionality is acid or protected acid such that aqueous development is possible using a basic developer such as sodium hydroxide solution, potassium hydroxide solution, or ammonium hydroxide solution. Some preferred fluorine-containing copolymers in the resist compositions of this invention are acid-containing copolymers or homopolymers comprised of at least one fluoroalcohol-containing monomer of structural unit:

$$-C(R_f)(R_f')OH$$

wherein $R_f$ and $R_f'$ are the same or different fluoroalkyl groups of from 1 to 10 carbon atoms or taken together are $(CF_2)$ n wherein n is 2 to 10. The level of acidic fluoroalcohol groups is determined for a given composition by optimizing the amount needed for good development in aqueous alkaline developer.

When an aqueous processable photoresist is coated or otherwise applied to a substrate and imagewise exposed to UV light, development of the photoresist composition may require that the binder material contain sufficient acid groups (e.g., fluoroalcohol groups) and/or protected acid groups that are at least partially deprotected upon exposure to render the photoresist (or other photoimageable coating composition) processable in aqueous alkaline developer. In case of a positive-working photoresist, the photoresist layer will be removed during development in portions which have been exposed to UV radiation but will be substantially unaffected in unexposed portions. Development of positive-working resists typically consists of treatment by aqueous alkaline systems, such as aqueous solutions containing 0.262 N tetramethylammonium hydroxide, at 25 °C for 2 minutes or less. In case of a negative-working photoresist, the photoresist layer will be removed during development in portions which are unexposed to UV radiation, but will be substantially unaffected in exposed portions. Development of a negative-working resist typically consists of treatment with a critical fluid or an organic solvent.

A critical fluid, as used herein, is a substance heated to a temperature near or above its critical temperature and compressed to a pressure near or above its critical pressure. Critical fluids in this invention are at a temperature that is higher than 15 °C below the critical temperature of the fluid and are at a pressure higher than 5 atmospheres below the critical pressure of the fluid. Carbon dioxide can be used for the critical fluid in the present invention. Various organic solvents can also be used as developer in this invention. These include, but are not limited to, halogenated solvents and non-halogenated solvents. Halogenated solvents are preferred and fluorinated solvents are more preferred. A critical fluid can comprise one or more chemical compounds.

Substrate

The substrate employed in this invention can illustratively be silicon, silicon oxide, silicon oxynitride, silicon nitride, or various other materials used in semiconductive manufacture.

This invention is further illustrated by the following examples that are provided for illustration purposes and in no way limit the scope of the present invention.

Examples (General)

In the Examples that follow, the following abbreviations are used:

ASM - p-Acetoxystyrene monomer
t-BPP - tert-butyl peroxypivalate
THF - Tetrahydrofuran
GPC - Gel permeation chromatography
GC - Gas chromatography
FTIR - Fourier transform infrared spectroscopy
NMR - Nuclear magnetic resonance spectroscopy, usually of either proton, $^1H$;
and/or carbon 13, $^{13}C$ nuclei.
DSC - Differential scanning calorimetry
UV-Vis - Ultraviolet-Visible Spectroscopy

General Analytical Techniques Used for the Characterization:A variety of analytical techniques were used to characterize the co- and terpolymers of the present invention that included the following:

NMR: $^1H$ and $^{13}C$ NMR spectra were recorded on a Bruker 400 MHz spectrometer with 5 mm probes at 400 and 100 MHz, respectively.
GPC:GPC was performed on a Waters gel permeation chromatograph equipped with refractive index detection.
GC:GC analysis was performed on a Hewlett Packard Model 5890 series II gas chromatograph equipped with a DB-1 column.
FTIR: FTIR was recorded on a Mattson Genesis Series FTIR.
DSC:A Perkin Elmer 7700 DSC was used to determine the $T_g$ (glass transition temperature) of the co- and terpolymers of this invention. The heating rate was maintained at 10°C/minute, generally, over a temperature range of 50°C to 400°C. The flow rate of nitrogen or air is maintained at 20 mL/min.
UV-Vis of samples were taken using a Hewlett Packard Vectra 486/33VL UV-Vis spectrophotometer.

Example 1

Low polydispersity polymers using RAFT.
Homopolymers of 4-hydroxystyrene

Polymerization

To a four neck, 1 liter round bottom flask, fitted with a condenser, mechanical stirrer, nitrogen inlet, and thermowell, 4-acetoxystyrene (ASM) (250.33 g, 1.5204 moles) and 1-methoxy-2-propanol (PGME) (269.4 g) were added. The reactor was heated to 100 °C using a heating mantle and temperature controller. Then, S-cyanomethyl-S-dodecyl trithiocarbonate (CDTC) (2.66 g, 0.83 mmoles) and t-butylperoxyacetate (tBPA) (0.214 g, 75 wt% in OMS, 0.12 mmoles) dissolved in 28.1 g of PGME were added. The reactor was maintained at 100 °C for 24.0 hours. The reactor was then cooled to room temperature. Analysis of the polymer obtained showed a weight average molecular weight of 14,400 and a polydispersity of 1.114, table 1.

Isolation

To 546 g of the polymer solution obtained above, 283 g of PGME was added to adjust the concentration of the polymer to 30 wt%. The solid polymer was then isolated by precipitation into methanol (10:1, methanol:polymer solution), filtered through a coarse frit, washed with methanol, and vacuum dried (55 °C, 20 torr, 24 hours). 116.5 g of a light yellow solid was obtained.

Deprotection/isolation

To a four neck, 1 liter round bottom flask, fitted with a condenser/Barrett receiver, mechanical stirrer, nitrogen inlet, and thermowell, 111.34 g of the solid obtained above, methanol (218.66 g), and sodium methoxide in methanol (25 wt% in methanol, 1.02 g) were added. The reactor was heated to reflux and was maintained at reflux for 6 hours with continuous take off of distillate. The distillate was replaced to the reactor continuously with methanol throughout the reaction. The reactor was then cooled to room temperature. The solution obtained was passed through a column of Amberlyst A15 resin (1" x 11", 10 mL/min) to remove the catalyst. The solid polymer was then isolated by precipitation into water (10:1, water:polymer solution), filtered through a coarse frit, washed with water, and vacuum dried (55 °C, 20 torr, 3 days). 75.35 g of a fine white solid was obtained (91.4% yield. 41.3 % overall yield). Analysis of the solid gave a weight average molecular weight of 12,820 with a polydispersity of 1.198. Thermal, molecular weight, and optical density information is given in table 2.

Table 1.

| Conversion and GPC results 10033-153 | | | | | |
|---|---|---|---|---|---|
| ASM Conversion | | | | GPC | |
| Sample | Time (mins) | Conc. (wt%) | Conversion | Peak 2 | |
| | | | | Mw | PD |
| 10033-153-1 | 0.0 | 45.00 | 0.00% | 152 | |
| 10033-153-2 | 118 | 43.93 | 2.38% | 3,388 | 1.200 |
| 10033-153-3 | 1060 | 28.72 | 36.18% | 12,264 | 1.122 |
| 10033-153-4 | 1443 | 24.89 | 44.69% | 14,400 | 1.114 |

Table 2.

| Analysis of 10033-153 | |
|---|---|
| Parameter | Result |
| UVTransperency | 143 L/M cm |
| $T_g$ | 176.5 °C |
| $M_w$ | 12,820 |
| $M_n$ | 10,699 |
| Polydispersity | 1.198 |

Example 2

Homopolymers of 4-acetoxystyrene
Reaction 10033-161

Polymerization

To a four neck, 1 liter round bottom flask, fitted with a condenser, mechanical stirrer, nitrogen inlet, and thermowell, 4-acetoxystyrene (ASM) (250.56 g, 1.5205 moles) and 1-methoxy-2-propanol (PGME) (273.5 g) were added. The reactor was heated to 100 °C using a heating mantle and temperature controller. Then, S-cyanomethyl-S-dodecyl trithiocarbonate (CDTC) (2.63 g, 0.83 mmoles) and 1,1-di(t-butylperoxy)-3,3,5-trimethylcyclohexane (TMCH) (0.56 g, 0.18 mmoles) dissolved in 20.7 g of PGME were added. The reactor was maintained at 100 °C for 26.4 hours. The reactor was then cooled to room temperature. Analysis of the polymer solution obtained showed a weight average molecular weight of 23,036 and a polydispersity of 1.294, table 3. Conversion of ASM to polymer was analyzed by gas chromatography to be 83.12%.

Table 3.

| Conversion and GPC results for 10033-161 | | | | | |
|---|---|---|---|---|---|
| 10033-161 ASM Conversion | | | | | |
| Sample | Time (mins) | Conc. (wt%) | Conversion | Molecular Weight | |
| | | | | Mw | PD |
| | 0.0 | 45.00 | 0.00% | 152 | |
| 10033-161-1 | 185 | 26.72 | 40.63% | 11,017 | 1.180 |
| 10033-161-2 | 1100 | 9.23 | 79.49% | 21,905 | 1.418 |
| 10033-161-3 | 1580 | 7.60 | 83.12% | 23,036 | 1.294 |

Example 3

Copolymer of 4-hydroxystyrene and styrene
Reaction 10033-177

Polymerization

To a four neck, 1 liter round bottom flask, fitted with a condenser, mechanical stirrer, nitrogen inlet, and thermowell, 4-acetoxystyrene (ASM) (212.50 g, 1.29 moles), styrene (23.86 g, 0.23 moles). propylene glycol methyl ether acetate (PGMEA) (273.09 g), S-cyanomethyl-S-dodecyl trithiocarbonate (CDTC) (7.05 g, 2.22 mmoles), and 1,1-di(t-butylperoxy)-3,3,5-trimethylcyclohexane (TMCH) (1.46 g, 0.48 mmoles) were added. The reactor was heated to 100 °C using a heating mantle and temperature controller. The reactor was maintained at 100 °C for 25.8 hours. The reactor was then cooled to room temperature. Analysis of the polymer obtained showed a weight average molecular weight of 10,782 and a polydispersity of 1.205, table 4. Conversion of ASM was 98.02% and styrene 95.43%.

Purification

The above product was purified using reverse precipitation using methanol as a non-solvent. To the stirred reactor, methanol was slowly added (351.0 g) until a thick solid was formed. The stirrer was stopped and the solids were allowed to settle for a period of 30 minutes. Then, 418.8 g of the top solution layer was removed by suction. To the resulting solids, PGMEA (679.1 g) was added and the mixture was stirred until the solids were completely dissolved. Again, to the stirred reactor, methanol was slowly added (190.9 g) until a thick solid was formed. The stirrer was stopped and the solids were allowed to settle for a period of 30 minutes. Then, 221.2 g of the top solution layer was removed by suction. To the resulting solids, PGMEA (87.2 g) was added and the mixture was stirred until the solids were completely dissolved. Finally, to the stirred reactor, methanol was slowly added (174.4 g) until a thick solid was formed. The stirrer was stopped and the solids were allowed to settle for a period of 30 minutes. Then, 344.5 g of the top solution layer was removed by suction. To the resulting solids, methanol (326.1 g) was added to adjust the solids content to 30 wt%.

Deprotection/isolation

To the above reactor, fitted with a condenser/Barrett receiver, mechanical stirrer, nitrogen inlet, and thermowell, sodium methoxide in methanol (25 wt% in methanol, 1.98 g) was added. The reactor was heated to reflux and was maintained at reflux for 4.3 hours with continuous take off of distillate. The distillate was replaced to the reactor continuously with methanol throughout the reaction. The reactor was then cooled to room temperature. The solution obtained was passed through a column of Amberlyst A15 resin (1" × 11", 8 mL/mm) to remove the catalyst. The solid polymer was then isolated by precipitation into water (10:1. water:polymer solution), filtered through a coarse frit, washed with water, and vacuum dried (55 °C, 20 torr, 3 days). 159.9 g of a fine white solid was obtained (88.2 % overall yield). Analysis of the solid gave a weight average molecular weight of 10,051 with a polydispersity of 1.210.

Table 4.

| Conversion and GPC results for 10033-177 | | | | | | | |
|---|---|---|---|---|---|---|---|
| 10033-177 ASM:Styrene Conversion | | | | | | | |
| ASM | | | | Styrene | | | |
| Sample | Time (mins) | Conc. (wt%) | Conversion | Conc. (wt%) | Conversion | GPC | |
| | | | | | | Mw | PD |
| | 0.0 | 40.42 | 0.00% | 4.60 | 0.00% | 152 | |
| 10033-177 | 76 | 24.81 | 38.62% | 4.09 | 11.09% | 3,552 | 1.157 |
| 10033-177 | 236 | 10.82 | 73.23% | 2.54 | 44.78% | 6,892 | 1.156 |
| 10033-177 | 1227 | 0.85 | 97.90% | 0.23 | 95.00% | 10,626 | 1.204 |
| 10033-177 | 1529 | 0.80 | 98.02% | 0.21 | 95.43% | 10,782 | 1.205 |

While specific reaction conditions, reactants, and equipment are described above to enable one skilled in the art to practice the invention, one skilled in the art will be able to make modifications and adjustments which are obvious extensions of the present invention. Such obvious extensions of or equivalents to the present invention are intended to be within the scope of the present invention, as demonstrated by the claims which follow.

**Claims**

**1.** A liquid phase process for preparing a photoresist composition containing polymer in solution and which polymer has a low polydispersity, which process comprises the steps of:

(A) polymerizing, in the presence of a thiocarbonylthio chain transfer agent, a substituted styrene monomer alone or in combination with a monomer or monomers selected from the group consisting of alkyl acrylates, ethylenically unsaturated co-polymerizable monomer or monomers and mixtures thereof, in a first solvent in the presence of an initiator for a sufficient period of time and at a sufficient temperature and pressure to form a polymer and first solvent mixture;
(B) optionally purifying the polymer and first solvent mixture by fractionation wherein additional first solvent is added to said mixture, said mixture is heated and/or stirred, the mixture is allowed to settle, the first solvent is decanted, and further first solvent is added, and repeating this fractionation at least once more;
(C) transesterifying said polymer wherein the polymer is refluxed at the boiling point of said first solvent in the presence of a catalyst for a sufficient period of time and at a sufficient temperature and pressure to form a reaction mixture containing a hydroxyl containing polymer and first solvent;
(D) optionally purifying said reaction mixture from step (C) wherein a second solvent is mixed with said reaction mixture in which said second solvent is immiscible, allowing the layers to separate, and removing said second solvent and any dissolved by-products and low weight average molecular weight polymers dissolved therein;
(E) passing said polymer through an ion exchange material in order to remove any catalyst therefrom and thus provide a substantially catalyst-free hydroxyl containing polymer solution;
(F) adding a third solvent, which is photoresist compatible, to said polymer from step (E) and then distilling off the first solvent at a temperature of at least the boiling point of said first solvent for a sufficient period of time in order to remove substantially all of said first solvent to provide a substantially pure polymer in solution in said third solvent.

**2.** A liquid phase process for preparing a substantially anhydrous and pure polymer and which comprises the steps of:

(A) polymerizing one or more substituted styrenes in combination with a thiocarbonylthio compound in a solvent in the presence of an initiator for a sufficient period of time and at a sufficient temperature and pressure to form a poly(substituted styrene) and solvent mixture;
(B) transesterifying said mixture of step (A) wherein said mixture is refluxed at the boiling point of said solvent in the presence of a catalyst for a sufficient period of time and at a sufficient temperature and pressure to form a reaction mixture containing a polymer and solvent;
(C) passing said reaction mixture of step (B) through an ion exchange material in to remove any catalyst therefrom and thus provide a substantially catalyst-free polymer solution;

(D) adding a second solvent to said polymer solution from step (C) and then distilling off the first solvent at a temperature of at least the boiling point of said first solvent for s sufficient period of time in order to remove substantially all of said first solvent to provide a substantially pure polymer in solution in said second solvent.

**3.** A process as claimed in claim 2 wherein the substituted styrene has the formula

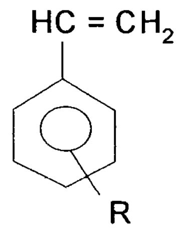

wherein R is $-OC(O)R_1$ or $-OR_1$ wherein $R_1$ is straight chain or branch chain $C_1$-$C_5$ alkyl.

**4.** A liquid phase process for preparing an anhydrous and pure polyhydroxystyrene and which comprises the steps of:

(A) polymerizing a substituted acetoxystyrene in combination with a thiocarbonylthio compound in a solvent in the presence of an initiator for a sufficient period of time and at a sufficient temperature and pressure to form a polysubstituted acetoxy styrene and solvent mixture;
(B) purifying the polysubstituted acetoxystyrene and solvent mixture by fractionation wherein additional solvent is added to said mixture, the mixture is allowed to settle, the solvent is decanted, and further solvent is added, and repeating this fractionation at least once more;
(C) transesterifying said purified mixture of step (B) wherein said mixture is refluxed at the boiling point of said solvent in the presence of a catalyst for a sufficient period of time and at a sufficient temperature and pressure to form a reaction mixture containing polyhydroxystyrene and solvent;
(D) passing said reaction mixture of step (C) through an ion exchange material in to remove any catalyst therefrom and thus provide a substantially catalyst-free polyhydroxystyrene solution;
(E) adding a second solvent to said polyhydroxystyrene solution from step (D) and then distilling off the first solvent at a temperature of at least the boiling point of said first solvent for a sufficient period of time in order to remove substantially all of said first solvent to provide a substantially pure polyhydroxystyrene in solution in said second solvent.

**5.** A process as claimed in any of claims 1 to 4 wherein the thiocarbonylthio compound is selected from:

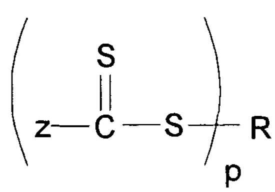

Formula C

and

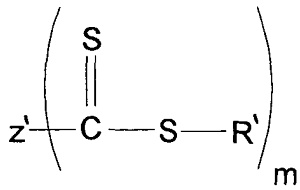

Formula D

having a chain transfer constant greater than about 0.1; and wherein:

z is selected from the group consisting of hydrogen, chlorine, optionally substituted alkyl, optionally substituted aryl, optionally substituted heterocyclyl, optionally substituted alkylthio, optionally substituted alkoxycarbonyl, optionally substituted aryloxycarbonyl (-COOR"), carboxy (-COOH), optionally substituted acyloxy ($-O_2CR''$), optionally substituted carbamoyl ($-CONR''_2$), cyano (-CN), dialkyl- or diarylphosphonato [$-P(=O)OR''_2$], dialkyl- or diaryl-phosphinato [$-P(=O)R''_2$], and a polymer chain formed by any mechanism;
z' is a m-valent moiety derived from a member of the group consisting of optionally substituted alkyl, optionally substituted aryl and a polymer chain; where the connecting moieties are selected from the group that consists of aliphatic carbon, aromatic carbon, and sulfur;
R is a p-valent moiety derived from a member of the group consisting of optionally substituted alkyl, an optionally substituted saturated, unsaturated or aromatic carbocyclic or heterocyclic ring;
optionally substituted alkylthio; optionally substituted alkoxy; optionally substituted dialkylamino; an organometallic species; and a polymer chain prepared by any polymerization mechanism;
R' is selected from the group consisting of optionally substituted alkyl, an optionally substituted saturated, unsaturated or aromatic carbocyclic or heterocyclic ring; optionally substituted alkylthio; optionally substituted alkoxy; optionally substituted dialkylamino; an organometallic species; and a polymer chain prepared by any polymerization mechanism;
in compounds C and D, R· or R'· is a free-radical leaving group that initiates free radical polymerization;
p is 1 or an integer greater than 1; and
m is an integer ≥2.

European Patent Office

# EUROPEAN SEARCH REPORT

Application Number
EP 04 25 2708

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | WO 99/57163 A (TRIQUEST LP) 11 November 1999 (1999-11-11) * claims; examples * | 1-5 | C08F2/38 G03F7/039 |
| Y | US 6 414 110 B1 (SHEEHAN MICHAEL T ET AL) 2 July 2002 (2002-07-02) * the whole document * | 1-5 | |
| Y | US 2002/156199 A1 (SHEEHAN MICHAEL T ET AL) 24 October 2002 (2002-10-24) * the whole document * | 1-5 | |
| D,Y | WO 98/01478 A (LE TAM PHUONG ; MOAD GRAEME (AU); RIZZARDO EZIO (AU); THANG SAN HOA (A) 15 January 1998 (1998-01-15) * the whole document * | 1-5 | |
| D,A | US 5 625 020 A (KNORS CHRISTOPHER J ET AL) 29 April 1997 (1997-04-29) * the whole document * | 1-5 | |

TECHNICAL FIELDS SEARCHED (Int.Cl.7)

G03F
C08F

The present search report has been drawn up for all claims

| Place of search | Date of completion of the search | Examiner |
|---|---|---|
| Munich | 27 September 2004 | Ludi, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 04 25 2708

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2004

| Patent document cited in search report | | Publication date | Patent family member(s) | | | Publication date |
|---|---|---|---|---|---|---|
| WO 9957163 | A | 11-11-1999 | AT | 262542 | T | 15-04-2004 |
| | | | AU | 3005899 | A | 23-11-1999 |
| | | | DE | 69915819 | D1 | 29-04-2004 |
| | | | EP | 1076667 | A1 | 21-02-2001 |
| | | | WO | 9957163 | A1 | 11-11-1999 |
| | | | US | 2002156199 | A1 | 24-10-2002 |
| US 6414110 | B1 | 02-07-2002 | AU | 4503501 | A | 12-06-2001 |
| | | | EP | 1228103 | A2 | 07-08-2002 |
| | | | TW | 526212 | B | 01-04-2003 |
| | | | WO | 0140321 | A2 | 07-06-2001 |
| US 2002156199 | A1 | 24-10-2002 | WO | 03089482 | A1 | 30-10-2003 |
| | | | AT | 262542 | T | 15-04-2004 |
| | | | AU | 3005899 | A | 23-11-1999 |
| | | | DE | 69915819 | D1 | 29-04-2004 |
| | | | EP | 1076667 | A1 | 21-02-2001 |
| | | | WO | 9957163 | A1 | 11-11-1999 |
| WO 9801478 | A | 15-01-1998 | AT | 210684 | T | 15-12-2001 |
| | | | AU | 728717 | B2 | 18-01-2001 |
| | | | AU | 3603397 | A | 02-02-1998 |
| | | | BR | 9710219 | A | 10-08-1999 |
| | | | CA | 2259559 | A1 | 15-01-1998 |
| | | | CN | 1228787 | A ,C | 15-09-1999 |
| | | | DE | 69709110 | D1 | 24-01-2002 |
| | | | DE | 69709110 | T2 | 25-04-2002 |
| | | | EP | 0910587 | A1 | 28-04-1999 |
| | | | ES | 2166092 | T3 | 01-04-2002 |
| | | | JP | 2000515181 | T | 14-11-2000 |
| | | | KR | 2000023688 | A | 25-04-2000 |
| | | | NZ | 333277 | A | 29-09-2000 |
| | | | TW | 384292 | B | 11-03-2000 |
| | | | WO | 9801478 | A1 | 15-01-1998 |
| | | | US | 2004171777 | A1 | 02-09-2004 |
| US 5625020 | A | 29-04-1997 | US | 5492793 | A | 20-02-1996 |
| | | | DE | 69322946 | D1 | 18-02-1999 |
| | | | DE | 69322946 | T2 | 12-08-1999 |
| | | | EP | 0605089 | A2 | 06-07-1994 |
| | | | JP | 3147268 | B2 | 19-03-2001 |
| | | | JP | 6266112 | A | 22-09-1994 |

EPO FORM P0459

For more details about this annex : see Official Journal of the European Patent Office, No. 12/82